Europäisches Patentamt

European Patent Office

Office européen des brevets

(19)

(11) Veröffentlichungsnummer : **0 172 485 B1**

(12) **EUROPÄISCHE PATENTSCHRIFT**

(45) Veröffentlichungstag der Patentschrift :
11.01.89

(21) Anmeldenummer : 85109827.7

(22) Anmeldetag : 05.08.85

(51) Int. Cl.⁴ : **H 01 L 25/16,** H 01 L 23/46, H 01 L 31/16

(54) Gemeinsames Gehäuse für zwei Halbleiterkörper.

(30) Priorität : 08.08.84 DE 3429234

(43) Veröffentlichungstag der Anmeldung :
26.02.86 Patentblatt 86/09

(45) Bekanntmachung des Hinweises auf die Patenterteilung : 11.01.89 Patentblatt 89/02

(84) Benannte Vertragsstaaten :
AT BE CH DE FR GB IT LI LU NL SE

(56) Entgegenhaltungen :
DE--A-- 2 515 341
DE--A-- 3 129 996
GB--A-- 1 563 091
US--A-- 3 706 010
IBM TECHNICAL DISCLOSURE BULLETIN, Band 22, Nr. 12, Mai 1980, Seiten 5288-5290, New York, US; W.B. ARCHEY et al.: "Low loss optical coupler"

(73) Patentinhaber : Siemens Aktiengesellschaft Berlin und München
Wittelsbacherplatz 2
D-8000 München 2 (DE)

(72) Erfinder : Langenwalter, Michael, Dr.
Schulerstrasse 8
D-8035 Stockdorf/Gauting 2 (DE)
Erfinder : Möhrmann, Karl Heinz, Dipl.-Ing.
Kemptener Strasse 65
D-8000 München 71 (DE)
Erfinder : Prussas, Herbert, Dipl.-Ing.
Mozartring 11
D-8069 Reichertshausen (DE)
Erfinder : Später, Lothar, Dipl.-Ing.
Am Klingelberg 21
D-6747 Annweiler am Trifels (DE)

## Beschreibung

Die Erfindung stellt eine Verbesserung des im Oberbegriff genannten speziellen Gehäuses dar, das für sich bekannt ist.

Die Erfindung stellt eine Lösung für ganz extreme Forderungen an die Kühlung beider Halbleiterkörper von unterschiedlicher höchstzulässiger Betriebstemperatur dar, wobei oft sogar beide Halbleiterkörper nahe ihrer höchstzulässigen Betriebstemperatur betrieben werden. Beide müssen also gut und zuverlässig gekühlt werden.

Ein solcher Betrieb tritt z. B. bei möglichst kleinen, räumlich ganz dicht nebeneinander angebrachten, durch kräftige Gebläse gekühlten Gehäusen mit optoelektronischen Wandlern mit Treiber insbesondere für Glasfasernachrichtensysteme auf. Als Wandler dient z. B. eine lichtemittierfähige IRED-Diode als vorderer, erster, kühlerer Halbleiterkörper, welcher trotz seiner z. B. 200 mW Verlustleistung höchstens z. B. 80 °C Sperrschichttemperatur aufweisen darf. Der hintere, zweite, heißere Halbleiterkörper, also der Treiber, darf bei z. B. 1 W Verlustleistung höchstens z. B. 125 °C erreichen. Zur Kühlung des Gehäuses steht als Kühlmedium z. B. 40 °C warme zuführbare Kühlluft mit einer Strömungsgeschwindigkeit von z. B. 100 m/min zur Verfügung. Das Gehäuse soll einschließlich seiner Glasfaser-Kupplung eine Größe von höchstens z. B. 49 mm × 16,2 mm × 8,4 mm aufweisen.

Ohne ganz besondere Kühlmaßnahmen wird das Gehäuse zu heiß und seine Halbleiterkörper sind dann nicht betriebsfähig. Die Aufgabe der Erfindung, eine zuverlässige Kühlung beider, nahe ihrer voneinander abweichenden höchstzulässigen Betriebstemperatur betriebenen Halbleiterkörper erreichen zu können, wird durch die im Patentanspruch 1 angegebenen Maßnahmen gelöst.

Mehrere Kühlmaßnahmen erwiesen sich nämlich als erforderlich, und zwar:

1. Die Wärme ist vom vorderen Halbleiterkörper (IRED-Diode) möglichst vollständig schon über den vorderen Abschnitt des Gehäuses (Glasfaser-Kupplung) an das umgebende Kühlmittel (Kühlluft) abzugeben.

2. Die Wärme von dem hinteren Halbleiterkörper (Treiber) ist möglichst vollständig hinter dem vorderen Abschnitt, also möglichst nicht über den ersten Abschnitt, abzugeben.

3. Die Wärme des vorderen Halbleiterkörpers (IRED-Diode) ist großflächig auf vom Kühlmedium (Kühlluft) umspülte Gehäuseoberflächen des vorderen Abschnittes zu verteilen.

4. Die Wärme des hinteren Halbleiterkörpers (Treiber) ist großflächig auf vom Kühlmedium (Kühlluft) umspülte Gehäuseoberflächen hinter dem vorderen Abschnitt, also weitgehend über Gehäuseoberflächen des hinteren Abschnittes zu verteilen.

5. Der Wärmefluß vom hinteren Abschnitt des Gehäuses zum vorderen Abschnitt des Gehäuses ist so zu drosseln, daß die Wärme des hinteren Halbleiterkörpers (bis 125 °C belastbarer Treiber mit 1 W Verlustleistung) nicht mehr den vorderen Halbleiterkörper (bis zu 80 °C belastbare IRED-Diode mit 200 mW Verlustleistung) aufheizen kann.

6. Der Wärmeübergangwiderstand zwischen Modul und Kühlmedium muß bei Bedarf zusätzlich, z. B. mittels vieler kleiner Rippen, ausreichend klein gemacht werden können, besonders wenn bei äußerst beengten Einbauverhältnissen (enge Luftspalte zwischen benachbarten Gehäusen) und ungünstigen vorgegebenen Kühlmedium-(Kühlluft-) Daten die zugelassenen Betriebstemperaturen beider Halbleiterkörper andernfalls überschritten würden.

Die in den Unteransprüchen angegebenen Maßnahmen gestatten zusätzliche Vorteile, nämlich die Maßnahmen gemäß Patentanspruch.

2 und 3, die Aufheizung des vorderen Halbleiterkörpers durch den hinteren, heißeren Halbleiterkörper über die Gehäusewand mit einfachen Maßnahmen stark zu drosseln,

4, die Aufheizung des vorderen Halbleiterkörpers durch den hinteren Halbleiterkörper über Teile im Inneren des Gehäuses mit einfachen Maßnahmen stark zu drosseln, sowie

5, eine möglichst gut kühlbare optoelektronische Wandlereinheit für Glasfasernachrichtensysteme zu bieten.

Die Erfindung und Weiterbildungen davon werden anhand der in den Figuren gezeigten Beispiele weiter erläutert, wobei die Figur

1 ein bereits in der Anmeldung DE-A-34 06 424 beschriebenes Gehäuse mit optoelektronischem Wandler für Glasfasernachrichtensysteme, jedoch mit noch nicht erfindungsgemäß im Gehäuse gemeinsam angebrachten Halbleiterkörpern, und

2 bis 4 erfindungsgemäße Ausführungsbeispiele, nämlich 2 eine teilweise geschnittene Seitenansicht des Gehäuses,

3 einen stark vergrößerten Längsschnitt durch den Bereich zwischen dem vorderem Abschnitt und dem hinterem Abschnitt eines optoelektronischen Wandler-Gehäuses für Glasfasernachrichtensysteme, sowie

4 eine Draufsicht auf mehrere, unter äußerst beengten Einbauverhältnissen dicht nebeneinander gepackte Gehäusen eines Glasfaser-Vermittlungssystemes zeigen (alle Längenangaben in mm-Einheiten !).

Fig. 1 zeigt also Details eines älteren, in der Anmeldung DE-A-34 06 424 beschriebenen optoelektronischen Modulgehäuses G/W, welches als lichtdichtes Sende- oder Empfangsmodulgehäuse dient. Es enthält einen Glasfaseranschluß SI, S, nämlich einen Glasfaserstecker SI, S mit Überwurf-Befestigungsmutter X zur Leitung von mit Informationen moduliertem Licht durch die Gehäusewand G über die Glasfaser M/L. Es enthält ferner eine optoelektronische Diode D, welche fest auf einer in einer ersten Dimension justierbaren Platte P innerhalb eines in zwei weiteren Dimensionen justierbaren Justierrahmens E angebracht ist. Zwischen dem Glasfaseranschluß SI, S und dem Bauelement D liegt eine Kugellinse K zur optischen Ankopplung der optisch aktiven Stelle der Diode D an das Glasfaserende.

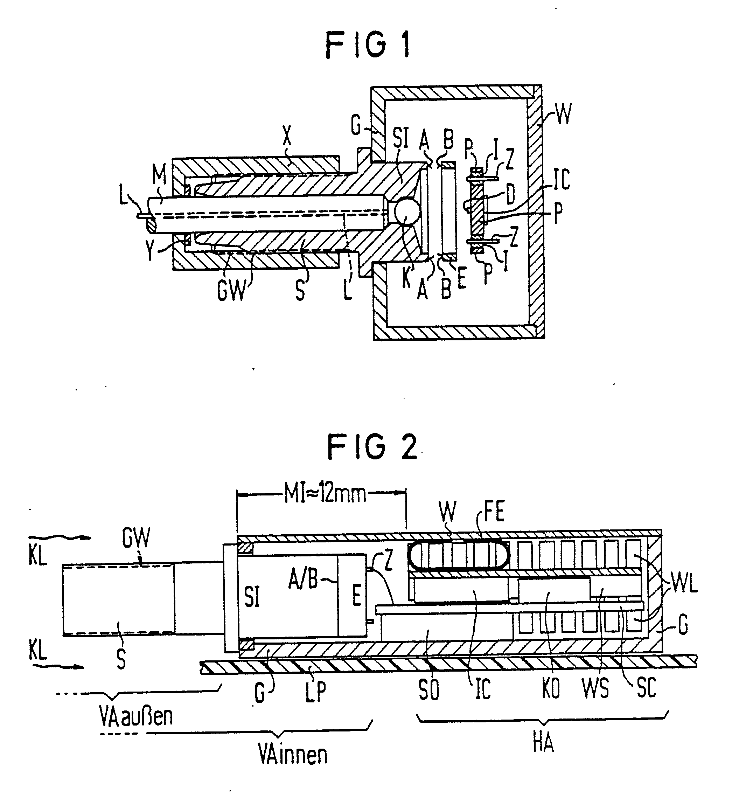

Das in Fig. 1 aufgeschnitten gezeigte ältere Modulgehäuse G/W enthält eine Wanne G, sowie einen, bevorzugt licht- und gasdicht, aufsetzbaren Deckel W, so daß das Innere dieses Modulgehäuses G/W für Montagen, Justierungen und abschließende Überprüfungen leicht zugänglich ist. Am Boden dieser Wanne G ist, wieder bevorzugt licht- und gasdicht, der Glasfaserstecker S für einen mittels der Mutter X und dem Anschlag Y festschraubbaren Glasfasersteckstift M, wobei in Richtung der Achse der Glasfaser L die Diode D, z. B. eine Laserdiode D, liegt.

Die in Fig. 1 in Seitenansicht gezeigte Platte P ist in Wahrheit in den Justierrahmen E geschoben. Der Justierrahmen E berührt zumindest mit einem Teil seiner Fläche B zumindest einen Teil der Fläche A des inneren Teils SI des Glasfasersteckers S. Da die Platte P in Richtung des Glasfaserachse verschiebbar ist und da der Justierrahmen E auf der Fläche A in zwei weiteren lateralen Richtungen bewegbar ist, ist die auf der Platte P befestigte Diode D in allen drei Dimensionen beliebig exakt justierbar. Nach dieser Justierung ist der Justierrahmen E an den Flächen A/B starr, also endgültig und bleibend, am Glasfaserstecker S und damit an der Wanne G befestigt, sowie, bevorzugt anschließend, die Platte P starr am Justierrahmen E und damit an der Wanne G befestigt. Diese Justierung sowie diese endgültigen starren Befestigungen an der Wanne G erfolgen bevorzugt unter Beobachtung bzw. Messung der optischen Kopplung zwischen Glasfaser L und Diode D, unter entsprechender optoelektronischer Inbetriebnahme der Diode D und der Glasfaser L, wobei angestrebt wird, durch die Justierung eine maximale, damit optimale optische Kopplung zwischen der Diode D und der Glasfaser L zu erreichen.

Die Kugellinse K kann — bei geeignet gewähltem Brechungsindex — so dicht neben der Diode und der Glasfaser befestigt werden, daß die Strahlung, und zwar trotz evtl. breiter Strahlungscharakteristik-Keule der Diode D, nur kleine Ausschnitte der Oberfläche der Kugellinse K durchdringt, aber als weitgehend parallel gebündelter dünner Strahl die Kugellinse K wieder verläßt, wodurch sogar eine besonders breite Keule der Diode D an eine schmale Strahlungscharakteristik-Keule des Glasfaserendes, zur Reduzierung von Reflexionen und Abbildungsungenauigkeiten, mehr oder weniger gut anpaßbar ist. Die Toleranz für den Abstand zwischen dem Glasfaserende und der benachbarten Linsenoberfläche, bei fest justierter Linse K, kann angenehmerweise insbesondere durch geeignete Wahl anderer Arten von Linsen, statt der einzigen Kugellinse K, fast beliebig groß gemacht werden. Der betreffende Abstand kann dann sogar extrem große Toleranzen aufweisen.

Bevorzugt wird die Diode D in der Mitte der Platte P befestigt. Die Platte P kann auch ein billiges normiertes Teil P sein, nämlich z. B. ein etwa 6 mm Durchmesser aufweisender gewöhnlicher Stiftsockel eines TO-Gehäuses, wobei die elektrischen äußeren Anschlüsse der Diode D einschließlich der Stromversorgung und Erdung auch über die mitgenormten, in Isolatoren I eingebetteten Durchführungen Z durch die Platte P hindurch geführt werden können. Überdies kann die Platte P, der Justierrahmen E und der Anschluß S/X aus elektrisch leitend miteinander verbundenen, geerdeten Metallmassen gebildet werden, wodurch auch eine sehr gute Hochfrequenzabschirmung der Diode D erreicht werden kann. Zusätzlich ist dann, wegen der Wärmeleitfähigkeit solcher Metallmassen, die Platte P und damit auch das Bauelement D relativ leicht über die Oberflächen des Gehäuses G/W kühlbar, besonders wenn auch das Gehäuse G/W aus Metall besteht und außen gut gekühlte Kühlrippen aufweist.

Auf der metallischen, geerdeten Platte P, auf der oft große Platznot herrscht, kann — auch aus Streukapazitätsgründen — auf ihrer rückseitigen Oberfläche, welche abgewandt ist von ihrer die Diode D tragenden Oberfläche, mindestens ein weiterer Halbleiterkörper, z. B. ein Treiber IC, angebracht sein, welcher hochfrequenzmäßig über z. B. jene Durchführungen Z elektrisch leitend mit der Diode D verbunden ist. So können dort bereits störende Hochfrequenzrückkopplungen zwischen diesem Treiber IC und der Diode D unterdrückt bzw. gedämpft werden. Hier besteht jedoch eine noch relativ enge thermische Kopplung zwischen dem Treiber IC, der gekühlten metallischen Platte P und der Diode D. Inzwischen wurde aber mit Überraschung festgestellt, daß diese thermische Kopplung schädlich ist, wenn die extremen Betriebsbedingungen vorliegen. — Im übrigen sind in jenen älteren Anmeldungen weitere Details und Varianten des in Fig. 1 gezeigten älteren Modulgehäuses angegeben.

Die in den Fig. 2 bis 4 gezeigten erfindungsgemäßen Gehäusebeispiele sind weitgehend wie das ältere Modulgehäuse aufgebaut, wie auch durch die Wahl von gleichen Hinweiszeichen erkennbar wird. Dementsprechend sind auch die Funktionen und Aufgaben entsprechend ähnlich, so daß im folgenden im wesentlichen nur noch auf die abweichenden Besonderheiten von der Erfindung und von deren Weiterbildungen eingegangen zu werden braucht.

In den Fig. 2 bis 4 sind also Beispiele gezeigt, bei denen im vorderen Abschnitt VA der vordere, erste Halbleiterkörper D, z. B. jene Diode, und im hinteren Abschnitt HA der hintere, zweite Halbleiterkörper IC, z. B. jener Treiber sowie evtl. noch weitere elektronische Bauteile wie z. B. ein Kondensator KO in Fig. 2, angebracht sind. Die maximale Betriebstemperatur des hinteren Halbleiterkörpers IC ist zumindest zeitweise höher als die maximale Betriebstemperatur des vorderen Halbleiterkörpers.

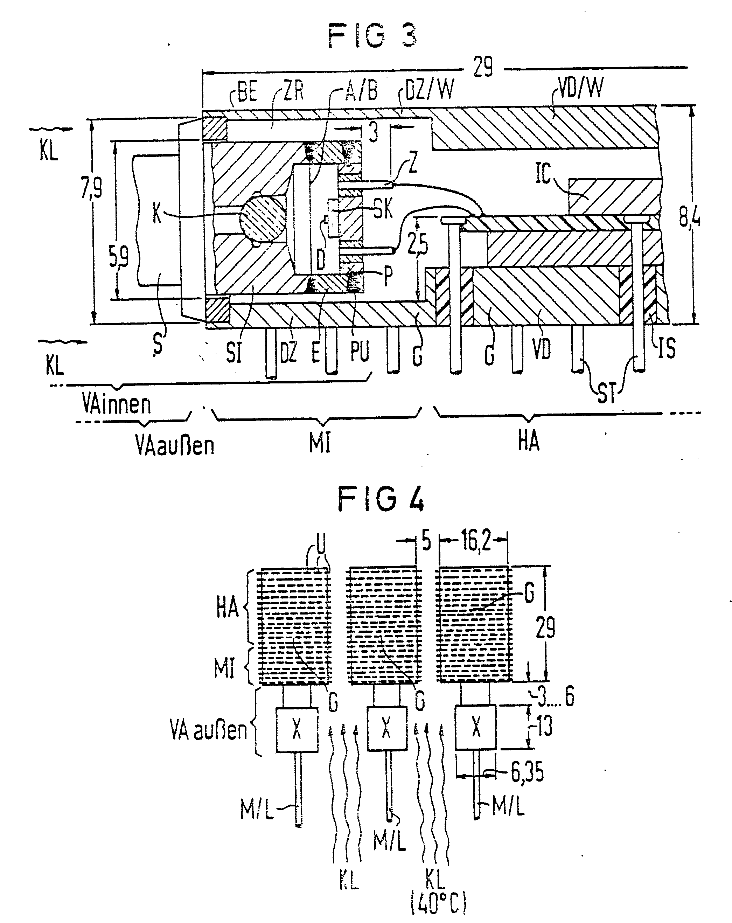

Der Wärmewiderstand zwischen dem vorderen Halbleiterkörper D (, der gem. Fig. 3 auch auf oder in einem wärmeleitenden Sockel SK angebracht sein kann) und einer wärmeleitend mit ihm verbundenen vorderen Kühlfläche GW/X der Gehäuseoberfläche am vorderen Abschnitt VA — sowie der Wärmewiderstand zwischen dem hinteren Halbleiterkörper IC und einer wärmeleitend mit ihm verbundenen hinteren, von der vorderen verschiedenen, Kühlfläche der Gehäuseoberfläche am hinteren Abschnitt HA, ist durch entsprechende Dimensionierungen der Gehäuseteile und der Teile im Inneren des Gehäuses, z. B. durch dafür jeweils für sich bekannte Dimensionierungen, jeweils niedriger als — sowohl der Wärmewiderstand im Gehäuseinneren zwischen den beiden Halbleiterkörpern D, IC — als auch der Wärmewiderstand zwischen der vorderen und der hinteren Kühlfläche.

Bei den erfindungsgemäßen Beispielen sind also die Wärmewiderstände ganz anders als bei dem älteren Modulgehäuse dimensioniert, was an dem in den Figuren gezeigten speziellen Beispielen demonstriert werden soll :

Der Wärmewiderstand im Gehäuseinneren zwischen den beiden Halbleiterkörpern D, IC wird nicht mehr, vgl. Fig. 1, im wesentlichen durch die relativ dünne metallische Platte P gebildet, sondern weitgehend nur noch über die elektrischen dünnen, relativ langen Anschlüsse, vgl. Z in Fig. 2 und 3, zwischen den beiden Halbleiterkörpern D, IC.

Außerdem ist nicht nur der Wärmewiderstand der vorderen Wärmeflußstrecke vom Inneren des vorderen Abschnittes VA innen zur vom Kühlmedium K umströmten vorderen Kühlfläche, also zwischen dem vorderen Halbleiterkörper D und der vom Kühlmedium K umströmten Oberfläche VA außen des vorderen Abschnittes SI, S, — wie schon bei dem älteren Modulgehäuse gem. Fig. 1 — klein zu machen, sondern auch der Wärmewiderstand einer eigenen Wärmeflußstrecke im hinteren Abschnitt HA vom Inneren des hinteren Abschnittes HA zu dessen vom Kühlmedium K umströmten hinteren Kühlfläche, also zwischen dem hinteren Halbleiterkörper IC und der vom Kühlmittel K umströmten Oberfläche des hinteren Abschnittes HA, für sich klein zu machen. Bei dem in Fig. 2 gezeigten Beispiel wird dieser niedrige Wärmewiderstand der hinteren Wärmeflußstrecke mit Hilfe von Blechen, vor allem von federnden Blechen WL, FE, evtl., noch über massive Zwischenteile, vgl. — nur als Beispiel eingezeichnet — den Sockel SO, erreicht, wobei solche den hinteren Halbleiterkörper IC hebenden Zwischenteile/Sockel SO zusätzlich dazu dienen können, daß die Länge der Hochfrequenzleitungen Z — z. B. für 200 MHz — möglichst klein werden.

Zur Verbesserung des Wärmeflusses von dem vorderen Halbleiterkörper D zur vorderen Kühlfläche kann man auch, vgl. Fig. 3 mit Fig. 1, den Justierrahmen und den an die Trennflächen A/B zum Stecker SI angrenzenden Teil des vorderen Abschnittes VA besonders dick machen und diese Trennflächen A/B z. B. verlöten oder verschweißen. Auch die Platte P kann besondere dick gemacht und in den Justierrahmen E eingelötet oder z. B. an möglichst vielen Punkten PU längs des Umfanges punktgeschweißt werden. Sowohl die Platte P als auch der Justierrahmen E kann aus besonders gut wärmeleitenden Materialen gemacht werden, z. B. aus Stahl MUS+42.

Bei dem in Fig. 2 gezeigten Beispiel sind die Dicken der Oberflächenschichten W, G des Gehäuses weitgehend gleichmäßig. Der notwendige hohe Wärmewiderstand zwischen der Oberfläche des hinteren Abschnittes HA und der Oberfläche des vorderen Abschnittes VA, der die Aufwärmung des kühleren vorderen Halbleiterkörpers D durch den heißeren hinteren Halbleiterkörper IC drosselt, wird hier vor allem durch die große Länge des Mittelabschnittes MI bestimmt. Dieser Mittelabschnitt MI wird nur mäßig über seine Angrenzungen an den vorderen Abschnitt VA und an den hinteren Abschnitt HA mit Wärmefluß von innen versorgt, aber von außen her durch das Kühlmedium K gekühlt. Ganz besonders wenig wird der vordere Halbleiterkörper D vom hinteren Halbleiterkörper IC aufgeheizt, wenn dieser Wärmewiderstand des Mittelabschnittes MI sowie dessen von Kühlmittel K gekühlte Oberfläche so dimensioniert werden, daß im Betrieb die Temperatur an der Gehäuseoberfläche in dem Mittelabschnitt MI zumindest stellenweise noch niedriger als die Temperaturen der Oberflächen sowohl des vorderen als auch des hinteren Abschnittes VA, HA ist.

Der notwendige, relativ hohe Wärmewiderstand zwischen der vorderen und hinteren Oberfläche kann auch durch Wahl eines geeigneten Mittelsbschnittsmaterials, z. B. Vacodil, das eine nur geringe Wärmeleitfähigkeit aufweist, erreicht werden ; ähnlich wärmewiderstandserhöhend wirken besonders dünne Wände DZ des Gehäuses im Mittelabschnitt MI, also zwischen dem vorderen Abschnitt VA und dem hinteren Abschnitt HA, vgl. das Beispiel in Fig. 3. Hierdurch wird nämlich im Mittelabschnitt MI die Querschnittsfläche der Gehäusewände G/W verringert und damit der Wärmewiderstand erhöht. Ähnlich wärmewiderstandserhöhend wirkt auch dort ein genügend großer Abstand zwischen den Gehäusewandverdickungen VD im hinteren Abschnitt HA und der Materialverdickungen bei P, E, SI im vorderen Abschnitt VA. Dieser Abstand beträgt bei dem in Fig. 3 gezeigtem Beispiel ebenfalls rund 12 mm — wie bei dem in Fig. 2 gezeigtem Beispiel, bei dem die Gehäusewandverdickungen VD fehlen und statt dessen wie wärmeableitenden federnden Bleche WL, FE zwischen dem hinteren Halbleiterkörper IC und der Gehäusewand W/G des hinteren Abschnittes angebracht sind.

Bei den in den Fig. 2 und 3 gezeigten Beispielen sind die beiden Halbleiterkörper D, IC mit speziellen, gut wärmeleitenden, dort sehr speziellen Befestigungselementen an ihren Abschnitten VA, HA befestigt. Es handelt sich dort um Gehäuse, bei denen, im Inneren SI, E, P des vorderen Abschnittes VA, der vordere Halbleiterkörper D an einem wärmeleitenden vorderen Befestigungselement P, E, A/B, SI, das gut wärmeleitend mit der Oberflächenschicht S, GW, S des vorderen Abschnittes VA verbunden ist, befestigt ist. Ferner ist dort im Inneren des hinteren Abschnittes HA der hintere Halbleiterkörper IC an einem wärmeleitenden hinteren, vom vorderen verschiedenen, Befestigungselement SC, WL, FE, SO, das gut wärmeleitend mit der hinteren Kühlfläche verbunden ist, befestigt. Hierbei ist aber unmittelbar zwischen dem vorderen Befestigungselement P, E, A/B, SI und dem hinteren Befestigungselement SC, WL, FE SO — abgesehen von der Wandung G, W des Gehäuses und abgesehen von elektrischen Leitungen bzw. Drähten Z — keine aus einem festen Körper bestehende Wärmebrücke angebracht. Diese Befestigungselemente sind leicht so zu gestalten bzw. zu dimensionieren und aus solchen Materialien herzustellen, daß die für die Erfindung geforderten niedrigen Wärmewiderstände zwischen den Halbleiterkörpern und zugeordneten Kühlflächen erreicht werden. Beispielsweise können diese Befestigungselemente so dimensioniert werden :

Die z. B. 0,15 × 0,25 mm² große Diode D sollte aus thermischen Gründen oft auf ihren Träger SK oder P nicht geklebt werden. Sie sollte oft wegen der besseren Wärmeleitung aufgelötet werden, wobei die Lotschichtdicke nicht mehr als z. B. 10 μm betragen sollte, um eine gut wärmeleitende Befestigung zu erreichen, was z. B. eine Verbesserung von 67 °K/W auf 1 °K/W bringt.

Der Träger SC für den Treiber IC kann z. B. statt aus dem Verbundmaterial Kupfer — Klebeschicht — Al₂O₃ — Keramik mit einer Dicke von z. B. 1,15 mm, auch aus BeO-/AlN-Keramik mit z. B. 0,4 mm Dicke bestehen, was zu einer Verbesserung der Wärmeleitfähigkeit von z. B. 8 °K/W auf 5 °K/W führen kann. Dieser Träger SC kann zusätzliche Bauelemente wie Schichtwiderstände und z. B. Kondensatoren KO und, z. B. aufgedruckte, Leitungen — auch für Hochfrequenz — tragen, wodurch die Drähte auch zwischen den Druchführungen Z und den Leitungen des Trägers SC angebracht werden können, vgl. Fig. 2 und 3.

Die Gehäuse weisen im allgemeinen, bevorzugt in Reihe angeordnete, Stromzuführungsstifte ST, vgl. Fig. 3, auf, mit denen sie in die Löcher einer Leiterplatte LP gesteckt werden können, vgl. Fig. 2. Diese Stifte ST können z. B. auch zur Zuleitung von Hochfrequenzsignalen zum Treiber IC dienen.

Wenn die Gehäuseoberfläche (bei der vorgesehenen Strömungsgeschwindigkeit des Kühlmediums und den zulässigen Temperaturen) zur Kühlung nicht ausreicht, besonders wenn die Gehäuse im Betrieb z. B. gemäß Fig. 4 dicht gepackt untergebracht sind, z. B. mit ihren Stromzuleitungsstiften ST in eine Leiterplatte dicht nebeneinander gesteckt sind, muß die Gehäuseoberfläche vergrößert werden, damit die ganze Wärme vom Kühlmedium in den oft sehr engen, vom Kühlmittel durchflossenen Spalten aufgenommen und abgeführt werden kann. Dazu kann man zumindest Teile der Kühlflächen mit Rippen, Noppen, Stacheln etc. vgl. U in Fig. 4, überziehen, notfalls auch die Kühlfläche des vorderen Abschnittes, also z. B. der Muttern X.

## Patentansprüche

1. Gemeinsames Gehäuse für zwei Halbleiterkörper (D, IC), nämlich mit vorderem (VA) und hinteren (HA) Abschnitt für zwei räumlich getrennte, im Gehäuseinneren angebrachte, bevorzugt aber elektrisch untereinander leitend verbundene Halbleiterkörper (D, IC), wobei, z. B. ganz aus Metall bestehende, Gehäuseoberflächen (W, G) im Betrieb durch ein fließfähiges Kühlmedium (KL), bevorzugt Kühlluft (KL), gekühlt werden,

— insbesondere Gehäuse für ein 200 MBit-Lichtsendemodul mit Hochfrequenzspannungs-Eingang (ST), mit Glasfaser-Ausgang (M/L) und mit einer Lichtsendediode (D) und einem Treiberchip (IC) als Halbleiterkörper,
dadurch gekennzeichnet, daß

— in seinem vorderen Abschnitt (VA) der vordere, erste Halbleiterkörper (D) und in seinem hinteren Abschnitt (HA) der hintere, zweite Halbleiterkörper (IC) angebracht ist,

— die maximale Betriebstemperatur des hinteren Halbleiterkörpers (IC) zumindest zeitweise höher als die maximale Betriebstemperatur des vorderen Halbleiterkörpers (D) ist,

— der Wärmewiderstand zwischen dem vorderen Halbleiterkörper (D) und einer wärmeleitend mit ihm verbundenen vorderen Kühlfläche (GW/X bzw. VA außen) der Gehäuseoberfläche am vorderen Abschnitt (VA), sowie

— der Wärmewiderstand zwischen dem hinteren Halbleiterkörper (IC) und einer wärmeleitend mit ihm verbundenen hinteren, von der vorderen verschiedenen, Kühlfläche der Gehäuseoberfläche am hinteren Abschnitt (HA) jeweils niedriger ist als

— sowohl der Wärmewiderstand im Gehäuseinneren zwischen den beiden Halbleiterkörpern (D, IC)

— als auch der Wärmewiderstand zwischen der vorderen und der hinteren Kühlfläche, und

— im Betrieb das Kühlmedium (KL) zuerst vorbei an der vorderen Kühlfläche und danach vorbei an der hinteren Kühlfläche fließt.

2. Gehäuse nach Patentanspruch 1, dadurch gekennzeichnet, daß

— die Gehäusewand (DZ) am Mittelabschnitt (MI), im Vergleich zur Gehäusewand (S/S, VD) am vorderen und am hinteren Abschnitt (VA, HA) zur Wärmewiderstandserhöhung mindestens eine dünne Stelle (DZ) bzw. Zone aufweist (Fig. 3).

3. Gehäuse nach Patentanspruch 1 oder 2, dadurch gekennzeichnet, daß

— im Betrieb die Temperatur an der Gehäuseoberfläche im Übergangsbereich zwischen der vorderen und der hinteren Kühlfläche zumindest stellenweise niedriger als die Temperaturen sowohl der vorderen als auch der hinteren Kühlfläche ist.

4. Gehäuse nach Patentanspruch 1, 2 oder 3, dadurch gekennzeichnet, daß

— im Inneren des vorderen Abschnittes (VA) der vordere Halbleiterkörper (D) an einem wärmeleitenden vorderen Befestigungselement (P, E, A/B, SI), das gut wärmeleitend mit der Oberflächenschicht (S, GW, X) des vorderen Abschnittes (VA) verbunden ist, befestigt ist, und

— im Inneren des hinteren Abschnittes (HA) der hintere Halbleiterkörper (IC) an einem wärmeleitenden hinteren, vom vorderen verschiedenen, Befestigungselement (SC, WL, FE, SO), das gut wärmeleitend mit der hinteren Kühlfläche verbunden ist, befestigt ist, aber

— unmittelbar zwischen dem vorderen Befestigungselement (P, E, A/B, SI) und dem hinteren Befestigungselement (SC, WL, FE, SO) — abgesehen von der Wandung (G, W) des Gehäuses und abgesehen von elektrischen Leitungen (Z) — keine aus einem festen Körper bestehende Wärmebrücke angebracht ist.

5. Gehäuse nach einem der vorhergehenden Patentansprüche, dadurch gekennzeichnet, daß

— der vordere Abschnitt (VA) eine lichtemittierfähige Diode (D) als vorderen Halbleiterkörper enthält,

— das vordere Befestigungselement (P, E, A/B, SI) gleichzeitig eine Justieranordnung zur Justierung der Lage der Diode (D) hinsichtlich eines Glasfaseranschlusses (K, L, M, S) darstellt,

— die vordere Kühlfläche zumindest Teile der Oberfläche (S, X) des Glasfaseranschlusses (L, M, K, S) enthält,

— der hintere Abschnitt (HA) einen Treiberchip (IC) als hinteren Halbleiterkörper enthält, und

— die hintere Kühlfläche Unebenheiten (Fig. 4), z. B. Spitzen, Rippen und/oder Löcher, aufweist.

## Claims

1. Common housing for two semiconductor bodies (D, IC), namely with front (VA) and rear (HA) section for two semiconductor bodies (D, IC), which are fitted inside the housing, are spatially separate but preferably connected to each other electrically conductively, housing surfaces (W, G), for example completely made of metal, being cooled in operation by a free-flowing cooling medium (KL), preferably cooling air (KL),

— in particular housing for a 200 Mbit optical transmission module with high-frequency voltage input (ST), with glass-fibre output (M/L) and with an optical transmission diode (D) and a driver chip (IC) as semiconductor bodies, characterized in that

— in its front section (VA), the front, first semiconductor body (D) is fitted and in its rear section (HA), the rear, second semiconductor body (IC) is fitted,

— the maximum operating temperature of the rear semiconductor body (IC) is at least temporarily higher than the maximum operating temperature of the front semiconductor body (D),

— the thermal resistance between the front semiconductor body (D) and a front cooling area (GW/X or VA outside), connected thermally conductively to it, of the housing surface on the front section (VA), and

— the thermal resistance between the rear semiconductor body (IC) and a rear cooling area, connected thermally conductively to it and different from the front area, of the housing surface on the rear section (HA) is in each case lower than

— both the thermal resistance inside the housing between the two semiconductor bodies (D, IC)

— and the thermal resistance between the front and the rear cooling area, and

— in operation, the cooling medium (KL) first flows past the front cooling area and then past the rear cooling area.

2. Housing according to Patent Claim 1, characterized in that

— the housing wall (DZ) on the middle section (MI) has at least one thin place (DZ) or zone (Fig. 3) in comparison with the housing wall (S/S, VD) on the front and on the rear section (VA, HA), to increase the thermal resistance.

3. Housing according to Patent Claims 1 or 2, characterized in that

— in operation, the temperature at the housing surface in the transition region between the front and the rear cooling area is lower at least in places than the temperatures both of the front and of the rear cooling area.

4. Housing according to Patent Claim 1, 2 or 3, characterized in that

— inside the front section (VA), the front semiconductor body (D) is fastened on a thermally conductive front fastening element (P, E, A/B, SI), which is connected with good thermal conductivity to the surface layer (S, GW, X) of the front section (VA), and

— inside the rear section (HA), the rear semiconductor body (IC) is fastened on a thermally conductive rear fastening element (SC, WL, FE, SO), which is different from the front one and is connected with good thermal conductivity to the rear cooling area, but

— no heat bridge consisting of a solid body is fitted directly between the front fastening element (P, E, A/B, SI) and the rear fastening element (SC, WL, FE, SO) — apart from the wall (G, W) of the housing and apart from electric leads (Z).

5. Housing according to one of the preceeding patent claims, characterized in that

— the front section (VA) contains a diode (D) capable of emitting light as front semiconductor body,

— the front fastening element (P, E, A/B, SI) at the same time represents an adjustment arrangement for adjusting the position of the diode (D) with respect to a glass fibre terminal (K, L, M, S),

— the front cooling area includes at least parts of the surface (S, X) of the glass fibre terminal (L, M, K, S),

— the rear section (HA) contains a driver chip (IC) as rear semiconductor body, and

— the rear cooling area has unevenesses (Fig. 4), for example peaks, ribs and/or holes.

## Revendications

1. Boîtier commun pour deux corps semiconducteurs (D, IC), à savoir avec une section antérieure (VA) et une section postérieure (HA) pour deux corps semiconducteurs (D, IC) séparés spatialement, montés à l'intérieur du boîtier et reliés entre eux mais de préférence reliés à conduction électrique, du type dans lequel des surfaces de boîtier (W, G) réalisées par exemple entièrement avec un métal, et qui sont, en fonctionnement, refroidies par un milieu de refroidissement capable de couler (KL), de préférence par de l'air de refroidissement,

— en particulier boîtier pour un module photoémetteur à 200 Mbit, à entrée (ST) d'une tension haute fréquence, à sortie à fibre de verre (M/L) et à diode photo-émissive (D) et avec une puce d'attaque (IC), comme corps semiconducteur, caractérisé par le fait que

— dans sa section antérieure (VA) est monté le premier corps semiconducteur antérieur (D) et dans sa section postérieure (HA) est monté le second corps semiconducteur postérieur (IC),

— la température maximale de fonctionnement du corps semiconducteur postérieur (IC) est, au moins de temps en temps, supérieure à la température maximale de fonctionnement du corps semiconducteur antérieur (D),

— la résistance thermique entre le corps semiconducteur antérieur (D) et une surface de refroidissement antérieure (GW/X ou VA extérieur), qui lui est reliée à conduction thermique, de la surface du boîtier de la section antérieure, de même que la résistance thermique entre le corps semiconducteur postérieur (IC) et une surface de refroidissement de la surface du boîtier de la section postérieure (HA), qui lui est reliée à conduction thermique et qui est différente de la surface de refroidissement antérieure, est plus faible aussi bien que la résistance thermique à l'intérieur du boîtier entre les deux corps semiconducteurs (D, IC), que la résistance thermique entre la surface de refroidissement antérieure et la surface de refroidissement postérieure, et

— en fonction, le milieu de refroidissement (KL) s'écoule d'abord devant la surface de refroidissement antérieure et ensuite devant la surface de refroidissement postérieure.

2. Boîtier selon la revendication 1, caractérisé par le fait que

— la paroi du boîtier (DZ) présente dans sa section médiane (MI), en vue d'un accroissement de la résistance thermique, au moins une partie (DZ) ou une zone mince, comparativement à la paroi de boîtier (S/S, VD) de la section antérieure et postérieure (VA, HA) (Figure 3).

3. Boîtier selon la revendication 1 ou 2, caractérisé par le fait que

— en fonctionnement, la température des surfaces du boîtier est, dans la zone de transition entre la surface de refroidissement antérieure et postérieure, au moins de place en place, inférieure aux températures aussi bien de la surface de refroidissement antérieure que de la surface de refroidissement postérieure.

4. Boîtier selon la revendication 1, 2 ou 3, caractérisé par le fait que

— à l'intérieur de la section antérieure (VA), le corps semiconducteur antérieur (D) est fixé à un élément de fixation antérieur (P, E, A/B, SI), à conduction thermique et qui est relié, avec bonne conduction thermique à la couche supérieure (S, GW, X) de la surface de la section antérieure (VA), et

— à l'intérieur de la section postérieure (HA), le corps semiconducteur postérieur (IC) est fixé à un élément de fixation postérieur (SC, WL, FE, SO) à conduction thermique, différent de l'élément de fixation antérieur, et qui est relié à bonne conduction thermique avec la surface de refroidissement postérieur, alors

— que directement entre l'élément de fixation antérieur (P, E, A/B, Si) et l'élément de fixation postérieur (SC, WL, FE, SO) et, abstraction faite de la paroi (GW) du boîtier et abstraction faite de conducteurs électriques, il n'est prévu aucun pont thermique constitué par un corps solide.

5. Boîtier selon l'une des revendications précédentes, caractérisé par le fait que

— la section antérieure (VA) comporte, en tant que corps semiconducteur antérieur, une diode capable d'une photo-émissivité,

— l'élément de fixation antérieur (P, E, A/B, SI) représente en même temps un dispositif de réglage pour ajuster la position de la diode par rapport à un raccordement de fibre optique (K, L, M, S),

— la surface de refroidissement antérieure comporte au moins des parties de la surface (S, X) du raccordement de fibre de verre (K, L, M, S),

— la section postérieure (HA) comporte, en tant que corps semiconducteur postérieur, une puce d'attaque (IC), et

— la surface de refroidissement postérieure présente des inégalités (Figure 4), par exemple des pointes, des nervures et/ou des trous.

# FIG 1

# FIG 2

## FIG 3

## FIG 4